# EUROPÄISCHE PATENTSCHRIFT

(11) **EP 1 647 116 B1**
(45) Veröffentlichungstag und Bekanntmachung des Hinweises auf die Patenterteilung: **30.01.2008**
(21) Anmeldenummer: 04722840.8
(22) Anmeldetag: 24.03.2004
(51) Int. Cl.: H04L 25/02, H03H 11/48

(54) **SCHALTUNGSANORDNUNG MIT ZWEI ELEKTRONISCHEN DROSSELN JE DATENLEITUNGSPAAR EINES LOKALEN NETZES**
CIRCUIT ARRANGEMENT COMPRISING TWO ELECTRONIC REACTANCE COILS PER DATA LINE PAIR OF A LOCAL NETWORK
ENSEMBLE CIRCUIT COMPRENANT DEUX BOBINES DE CHOC ELECTRONIQUES POUR CHAQUE PAIRE DE LIGNES DE TRANSMISSION DE DONNEES D'UN RESEAU LOCAL

(30) Priorität: 18.07.2003 DE 10332841
(43) Veröffentlichungstag der Anmeldung: 19.04.2006
(73) Patentinhaber: SIEMENS AKTIENGESELLSCHAFT, 80333 München (DE)
(72) Erfinder: NEUHAUS, Hans-Jürgen, 12161 Berlin (DE)
(86) Internationale Anmeldenummer: PCT/EP2004/003133
(87) Internationale Veröffentlichungsnummer: WO 2005/018182

(56) Entgegenhaltungen:
- EP-A- 0 590 242
- US-A- 4 004 104

## Beschreibung

Die Erfindung betrifft ein Verfahren und eine Vorrichtung zur Stromversorgung eines Verbrauchers (Strom-Senke) über zwei Datenleitungspaare eines lokalen Netzes.

In lokalen Netzen (Local Area Networks = LAN), bei denen die physische Datenübertragung beispielsweise über 4-Draht-Datenleitungen (Twisted pairs) erfolgt, wird die Speisung von Endgeräten in der Regel über zusätzliche Drähte geführt.
Auf Grund vorgegebener Installationen und/oder zur besseren Ausnutzung von Kabel-Installationen kann es von Vorteil sein, die Speisung von Endgeräten über die vier Datenleitungen - also ohne zusätzliche Speiseadern - zu führen. Dieses Prinzip ist für LANs mit Standard Ethernet Kabel im IEEE-Dokument "802.3af-2003" standardisiert. Beispielsweise kann ein über ein LAN vernetzter Rechner-Arbeitsplatz durch ein aus dem LAN gespeistes IP-Festnetzendgerät ergänzt werden, ohne die vorhandene 8-adrige Standard-Verkabelung (Twisted pair) zu verändern bzw. zu erweitern.

Bei der Speisung über die Datenleitungen werden in der Regel Phantom-Speiseschaltungen eingesetzt. Hier wird die SpeiseSpannung niederohmig in die Mittelanzapfungen der Nutzsignal-Übertrager eingespeist. Hierbei muss die Konstruktion des Übertragers so ausgeführt werden, dass der Speise-Gleichstrom keine Sättigung des Übertrager-Kerns hervorruft. Ist dies gewährleistet führt die niederohmige Speisespannungs-Einkopplung zu keiner Beeinflussung der Nutzsignale, da sich die Nutzsignale an der Mittelanzapfung des Übertragers, dem Einspeisepunkt der Gleichspannung, genau aufheben (Brückenschaltung). Die Nutzsignale werden hier auf der Sekundär-Seite (Rx, Tx) des jeweiligen Übertragers ein- und ausgekoppelt. Für die Phantomschaltungen werden Übertrager verwendet, die einen relativ hohen Raumbedarf, insbesondere eine große Bauhöhe und hohe Kosten gegenüber anderen elektronischen Standard-Bauelementen aufweisen.

Die EP 0590242 A1 beschreibt eine Schaltungsanordnung für die Speisung von Endeinrichtungen in Kommunikationsnetzen, bei der die Speisequelle den Schnittstellen der Netzabschlusseinheiten und die Senken den Schnittstellen der Endeinrichtungen zugeordnet sind. D1 verwendet statt herkömmliche Übertrager für die Phantomspeisung elektronische Drosseln, wobei je Leitungsader Kondensatoren für die Signalein- und die Signalauskopplung der Informationsübertragung vorgesehen sind.

Die Aufgabe der vorliegenden Erfindung besteht darin, eine Platz sparende und kosteneffektive Möglichkeit für die Ein- und/oder Auskopplung einer Speise-Spannung in ein lokales Netz vorzuschlagen.

Die Aufgabe wird erfindungsgemäß durch die Gegenstände der unabhängigen Patentansprüche gelöst. Weiterbildungen der Erfindung sind in den Unteransprüchen angegeben. Ein Kern der Erfindung besteht darin, dass zur Stromversorgung eines Verbrauchers (Strom-Senke) RL über zwei Datenleitungspaare eines lokalen Netzes (LAN) eine Schaltungsanordnung mit zwei elektronischen Drosseln je Datenleitungspaar verwendet wird und dass zur Bildung einer Selbst-Symmetrie der Schaltungsanordnung die beiden Basis-Anschlüsse und die beiden Ausgangs-Anschlüsse von je zwei elektronischen Drosseln eines Datenleitungspaares zusammengeschaltet werden. Ein Vorteil dieser Erfindung besteht in der hohen Kosteneffizienz und Raumersparnis gegenüber der Verwendung von Übertrager in Phantomschaltungen.

Die Erfindung wird anhand eines in den Figuren dargestellten Ausführungsbeispiels näher erläutert. Im Einzelnen zeigen
- Figur 1: eine Darstellung einer herkömmlichen Phantomschaltung,
- Figur 2: eine Schaltungsanordnung von zwei elektronischen Drosseln,
- Figur 3: eine Darstellung mit einer erfindungsgemäßen Schaltungsanordnung.

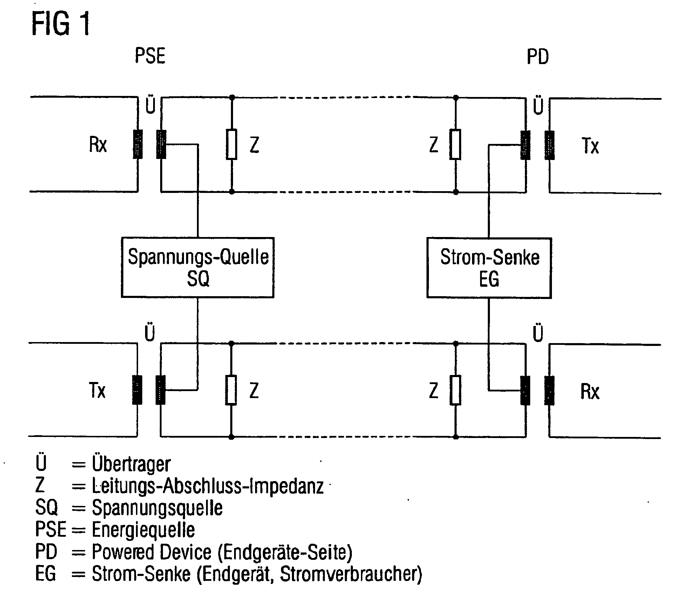

Figur 1 zeigt eine herkömmliche Phantomschaltung. Bei dieser Phantomschaltung werden Übertrager Ü verwendet, über die eine Speise-Spannung von der Energiequelle PSE (Power Source Equipment) z.B. eines sogenannten Switches (Schalter) in eine Datenleitung eines Netzes eingespeist wird. Beim Vierdrahtbetrieb stellt Tx eine Senderichtung und Rx eine Empfangsrichtung der Datenleitungen dar. Die Speise-Spannung wird an einem weiteren Übertrager Ü der Endgeräte-Seite PD abgegriffen und dem nicht weiter dargestellten Endgerät (Stromverbraucher) EG als Speisung zur Verfügung gestellt.

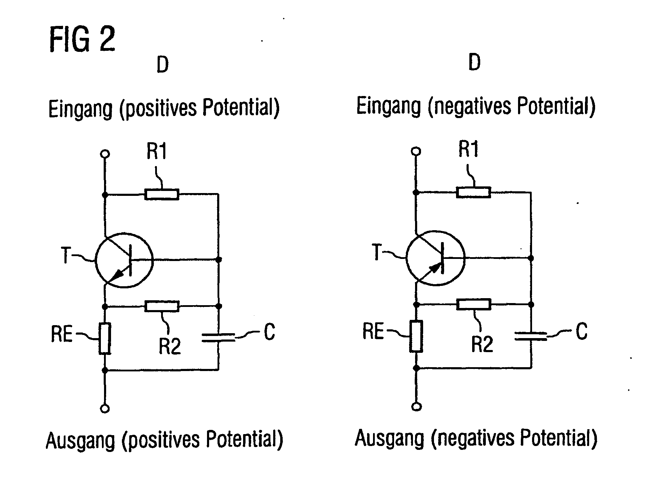

Figur 2 zeigt eine Schaltungsanordnung je einer elektronischen Drossel D für die Auskopplung des positiven sowie des negativen Potentials mit einem Ein- und Ausgang, elektrischen Widerständen R1 und R2, einem Emitterwiderstand RE, einem Transistor T und einem Kondensator C. Eine elektronische Drossel D kann aus verschiedenen passiven und/oder elektronischen Bauelementen bestehen und hat einen niedrigen Gleichstrom- und einen hohen Wechselstromwiderstand. Derartige elektronische Drosseln D sind z. B. bekannt aus der DE 38 26 765 C2.

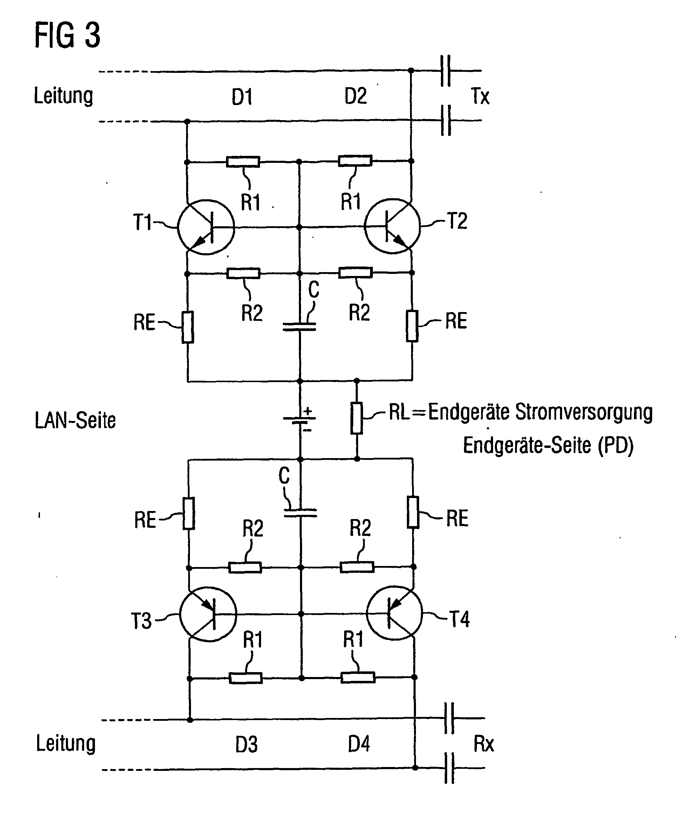

Figur 3 zeigt eine Darstellung mit einer erfindungsgemäßen Schaltungsanordnung zur Stromversorgung eines Verbrauchers (Strom-Senke) über zwei Datenleitungspaare eines lokalen Netzes (LAN). Die Signalein- bzw. Signalauskopplung erfolgt kapazitiv. In einem 4-Draht-LAN-Netz werden an die elektronischen Drosseln hohe Symmetrieanforderungen gestellt. Es muss gewährleistet sein, dass die Speisespannungs-Auskopplung zu keiner Beeinflussung der Nutzsignale führt. Aus diesem Grund werden für eine Schaltungsanordnung je zwei elektronische Drosseln D1/D2 und D3/D4 für ein Datenleitungspaar verwendet. Die elektronischen Drosseln D1/D2 und D3/D4 sind zueinander komplementär ausgelegt. Die Symmetrieanforderungen, die an jedes Drosselpaar D1/D2 und D3/D4 gestellt sind, werden zum einen durch identische Dimensionierungen der Drosseln D1/D2 und D3/D4, zum anderen aber wesentlich durch eine zusätzliche Verbindung der beiden Basis-Anschlüsse sowie der Drosselausgänge von D1 und D2 sowie D3 und D4 bestimmt. Durch die Verbindung der beiden Basis-Anschlüsse sowie der Drosselausgänge z. B. von D1 und D2 führt eine erhöhte Stromaufnahme einer Drossel (z. B. D1) zu einem Anstieg des Spannungsabfalls am Emitterwiderstand RE. Dies bewirkt gleichzeitig einen Anstieg der Basisspannung des Transistors T1 der elektronischen Drossel D1. Durch die Verbindung der Basisanschlüsse sowie der Drosselausgänge wird auch das Basispotential des Transistors T2 angehoben, was zu einem erhöhten Stromfluss durch die elektronische Drossel D2 führt und damit dem Stromanstieg durch die elektronischen Drossel D1 entgegenwirkt. Die Verbindung der Basis-Anschlüsse sowie der Drosselausgänge führt zu einem Regelprozess zur Selbst-Symmetrie, der in einfacher Weise zu einer weitgehend symmetrischen Auskopplung des Laststroms aus dem jeweiligen Datenleitungspaar führt. Die Symmetrie kann durch die Wahl von gleichen Transistor-Typen T1, T2 sowie T3, T4 mit gleichen Parametern, insbesondere mit gleicher Stromverstärkung, verbessert werden. Das erfindungsgemäße Verfahren wirkt in der komplementären Schaltungsanordnung mit den elektronischen Drosseln D3 und D4 für die Auskopplung des negativen Potentials identisch. Die elektronischen Drosseln D1/D2 und D3/D4 sind so dimensioniert, dass der Spannungsabfall über den jeweiligen Transistor (T1, T2, T3, T4) etwas größer ist als die Summe aus maximaler Signalspannungsamplitude und Transistor-Sättigungsspannung. Der erforderliche Spannungsabfall kann durch die Dimensionierung der Widerstände R1 und R2 eingestellt werden. Eine Sättigung der Transistoren T1, T2, T3, T4 muss vermieden werden, da sonst eine massive Begrenzung der Nutz-SignalAmplitude erfolgt. Der Eingangswiderstand jeder elektronischen Drossel entspricht in etwa dem Wert des elektrischen Widerstandes R1, wenn die Sättigung der Transistoren vermieden wird. Der Kondensator C verhindert zum einen, dass Unsymmetrien auf einem Datenleitungspaar zur Modulation der elektronischen Drossel führen. Weiterhin verhindert der Kondensator C, dass schnelle Verbrauchs-LastÄnderungen des Endgerätes (Strom-Senke) RL auf das entsprechende Datenleitungspaar übertragen werden. Die Speise-Spannung wird für das Endgerät (Strom-Senke) RL von einer Energiequelle PSE (Power Source Equipment) z. B. eine Switches (Schalter) zur Verfügung gestellt.

## Patentansprüche

1. Verfahren zur Stromversorgung eines Verbrauchers (Strom-Senke RL) über zwei Datenleitungspaare eines lokalen Netzes (LAN),
**dadurch gekennzeichnet, dass**
für eine Auskopplung einer von einer Energiequelle (PSE) zur Verfügung gestellten Speise-Spannung eine Schaltungsanordnung mit zwei elektronischen Drosseln (D1/D2, D3/D4) je Datenleitungspaar, welche an eine jeweils andere Ader des jeweiligen Datenleitungspaares angeschlossen werden und je einen Transistor (T1/T2, T3/T4) mit einem Basisanschluss enthalten, verwendet wird und
**dass** bei der Schaltungsanordnung die zwei elektronischen Drosseln (D1/D2, D3/D4) eines Datenleitungspaares über ihre Ausgangsanschlüsse und über die Basis-Anschlüsse ihrer jeweiligen Transistoren (T1/T2, T3/T4) miteinander zusammengeschaltet werden.

2. Verfahren nach Anspruch 1,
**dadurch gekennzeichnet, dass**
die zwei elektronischen Drosseln (D1/D2, D3/D4) in einer Schaltungsanordnung für je ein Datenleitungspaar identisch dimensioniert sind.

3. Verfahren nach einem der vorhergehenden Ansprüche,
**dadurch gekennzeichnet, dass**
die Ausgänge der elektronischen Drosseln (D1/D2, D3/D4) paarweise miteinander verbunden sind.

4. Vorrichtung zur Stromversorgung eines Verbrauchers (Strom-Senke RL) über zwei Datenleitungspaare eines lokalen Netzes (LAN),
- mit zwei elektronischen Drosseln (D1/D2, D3/D4) je Datenleitungspaar in einer Schaltungsanordnung, welche an eine jeweils andere Ader des jeweiligen Datenleitungspaares angeschlossen sind und je einen Transistor (T1/T2, T3/T4) mit einem Basisanschluss enthalten, zum Auskoppeln einer von einer Energiequelle (PSE) zur Verfügung gestellten Speise-Spannung, wobei
- die zwei elektronischen Drosseln (D1/D2, D3/D4) eines Datenleitungspaares über ihre Ausgangs-Anschlüsse, und über die Basis-Anschlüsse ihrer jeweiligen Transistoren (T1/T2, T3/T4) miteinander zusammengeschaltet sind.

## Claims

1. Method for supplying power to a load (current sink RL) via two data line pairs of a local area network (LAN),
**characterised in that**
in order to allow extraction of a supply voltage which is provided by an energy source (PSE), use is made of a circuit arrangement including two electronic chokes (D1/D2, D3/D4) per data line pair, said chokes being connected in each case to a different wire of the respective data line pair and containing in each case a transistor (T1/T2, T3/T4) with a base terminal, and that
in the circuit arrangement, the two electronic chokes (D1/D2, D3/D4) of a data line pair are connected together via their output terminals and via the base terminals of their respective transistors (T1/T2, T3/T4).

2. Method according to claim 1,
**characterised in that**
the two electronic chokes (D1/D2, D3/D4) in a circuit arrangement for a data line pair in each case are dimensioned in an identical manner.

3. Method according to one of the preceding claims,
**characterised in that**
the outputs of the electronic chokes (D1/D2, D3/D4) are connected together in a paired manner.

4. Device for supplying power to a load (current sink RL) via two data line pairs of a local area network (LAN),
- comprising two electronic chokes (D1/D2, D3/D4) per data line pair in a circuit arrangement, said chokes being connected in each case to a different wire of the respective data line pair and containing in each case a transistor (T1/T2, T3/T4) with a base terminal, for extracting a supply voltage which is provided by an energy source (PSE), wherein
- the two electronic chokes (D1/D2, D3/D4) of a data line pair are connected together via their output terminals and via the base terminals of their respective transistors (T1/T2, T3/T4).

## Revendications

1. Procédé d'alimentation en courant d'un consommateur (puits de courant RL) par deux paires de lignes de données d'un réseau (LAN) local,
**caractérisé en ce que**
pour un découplage d'une tension d'alimentation mise à disposition par une source (PSE) d'énergie, il est utilisé un montage ayant deux bobines (D1/D2, D3/D4) électroniques par paire de lignes de données, qui sont raccordées à respectivement un autre brin de la paire de lignes de données respectives et qui comportent respectivement un transistor (T1/T2, T3/T4) ayant une borne de base, et
**en ce que**, lors du montage, les deux bobines (D1/D2, D3/D4) électroniques, d'une paire de lignes de données sont connectées ensemble par leur borne de sortie et par les bornes de base de leur transistor (T1/T2, T3/T4) respectif.

2. Procédé suivant la revendication 1,
**caractérisé en ce que**
les deux bobines (D1/D2, D3/D4) électroniques sont de mêmes dimensions dans un montage pour respectivement une paire de lignes de données.

3. Procédé suivant l'une des revendications précédentes,
**caractérisé en ce que**
les sorties des bobines (D1/D2, D3/D4) électroniques sont reliées entre elles par paire.

4. Dispositif d'alimentation en courant d'un consommateur (puits de courant RL) par deux paires de lignes de données d'un réseau (LAN) local,
- comprenant deux bobines (D1/D2, D3/D4) électroniques par paire de lignes de données dans un montage, qui sont reliées respectivement à un autre brin de la paire de lignes de données respective et qui comportent respectivement un transistor (T1/T2, T3/T4) ayant une borne de base pour le découplage d'une tension d'alimentation mise à disposition par une source (PSE) d'énergie, dans lequel
- les deux bobines D1/D2, D3/D4) électroniques d'une paire de lignes de données sont connectées ensemble par leur borne de sortie et par les bornes de base de leur transistor (T1/T2, T3/T4) respectif.
